(19) Europäisches Patentamt
European Patent Office
Office européen des brevets

(11) **EP 1 964 207 B1**

(12) **EUROPEAN PATENT SPECIFICATION**

(45) Date of publication and mention
of the grant of the patent:
**30.05.2018 Bulletin 2018/22**

(51) Int Cl.:
***H04B 1/04*** *(2006.01)*   ***H03F 1/02*** *(2006.01)*
***H04B 7/06*** *(2006.01)*

(21) Application number: **06827452.1**

(22) Date of filing: **02.11.2006**

(86) International application number:
**PCT/US2006/042957**

(87) International publication number:
**WO 2007/056137 (18.05.2007 Gazette 2007/20)**

(54) **AMPLIFYING A TRANSMIT SIGNAL USING A FRACTIONAL POWER AMPLIFIER**

VERSTÄRKUNG EINES SENDESIGNALS ÜBER EINEN FRAKTIONAL-LEISTUNGSVERSTÄRKER

AMPLIFICATION D'UN SIGNAL D'EMISSION AU MOYEN D'UN AMPLIFICATEUR DE PUISSANCE FRACTIONNELLE

(84) Designated Contracting States:
**AT BE BG CH CY CZ DE DK EE ES FI FR GB GR HU IE IS IT LI LT LU LV MC NL PL PT RO SE SI SK TR**

(30) Priority: **03.11.2005  US 268260**
       **31.05.2006  US 803525 P**

(43) Date of publication of application:
**03.09.2008   Bulletin 2008/36**

(73) Proprietor: **Google LLC**
**Mountain View, CA 94043 (US)**

(72) Inventors:
• **HAREL, Haim**
  **New York, NY 10013 (US)**
• **KARMI, Yair**
  **Bridgewater, Somerset County, NJ 08807 (US)**

(74) Representative: **Boult Wade Tennant**
**Verulam Gardens**
**70 Gray's Inn Road**
**London WC1X 8BT (GB)**

(56) References cited:
**US-A- 5 862 461          US-A- 5 862 461**
**US-A1- 2003 002 594     US-A1- 2005 143 024**
**US-B1- 6 397 090          US-B1- 6 859 643**
**US-B2- 7 209 720**

## Description

## Technical Field

This invention relates generally to the field of wireless communications and more specifically to amplifying a transmit signal using a fractional power amplifier.

## Background

A transmitting communication device may have multiple antenna elements that transmit signals to communicate information. A receiving communication device extracts the information from the transmitted signals. Multiple antenna elements may enhance spectral efficiency, allowing for more users to be simultaneously served over a given frequency band.

Generally, transmit diversity techniques may involve transmitting radio frequency (RF) power through at least two channels. However, using the same full power amplifier for each RF channel may not be power efficient because the amplifier stage may output RF power below the rated power for some of the time of operation. Amplifying the signals for transmission, therefore, may burden the power source of the transmitting communication device.

US 6,859,643 describes first and second diversity, - encoded signals used to form a first and second composite signal.

US 5,862,461 describes an optimal signal line selected from a plurality of signal lines having different gains.

US 2003/0002594 describes a communication device having a set of antenna elements.

## Summary of the Disclosure

In accordance with the present invention, disadvantages and problems associated with previous techniques for amplifying signals may be reduced or eliminated.

In accordance with one aspect of the invention, there is provided a mobile wireless communication device as described in claim 1.

In accordance with another aspect of the invention, there is provided a method for transmission of a signal as described in claim 7.

Embodiments of the present invention may contain a transmit amplifier stage operable to amplify a transmit signal, that may comprise power amplifiers and switches. The power amplifiers may include at least one full power amplifier operable to provide full power to amplify the transmit signal and may include at least one fractional power is a fraction of the full power. In some embodiments of the present invention, full power may refer to power operable to support an air interface using a single transmit antenna. In embodiments of the invention, a switch may have a plurality of positions, where each or any position, for example, may direct the transmit signal to a selected power amplifier.

Certain embodiments of the invention may provide one or more technical advantages. For example, a technical advantage of one embodiment may be that a transmit amplifier stage includes a fractional power amplifier, which may be selected to amplify a transmit signal with a fractional power output. In some embodiments of the invention, the fractional power amplifier may consume less power than a full power amplifier for the same power output, so that the power consumption may be decreased. In some embodiments of the invention, similar transmit amplifier stages may be used to amplify multiple transmit signals to be transmitted from multiple antennas. The multiple transmit signals may be used to perform a transmit diversity operation, which may compensate for multipath fading and suppress interference signals. It will be recognized that different embodiments of the invention may support none, some, or all of the above technical advantages, and that the invention is not limited by the recitation herein of any certain advantages of the invention. One or more additional or other technical advantages may be readily apparent to one skilled in the art from the figures, descriptions, and claims included herein.

## BRIEF DESCRIPTION OF THE DRAWINGS

The subject matter regarded as the invention is particularly pointed out and distinctly claimed in the concluding portion of the specification. The invention, however, both as to organization and method of operation, together with objects, features, and advantages thereof, may best be understood by reference to the following detailed description when read with the accompanying drawings in which:

FIGURE 1 is a block diagram illustrating a communication network that includes a modifying communication device comprising one embodiment of an amplifier stage operable to amplify a signal;

FIGURE 2 is a block diagram illustrating one embodiment of a transmitter output stage that includes an amplifier stage operable to amplify a signal;

FIGURE 3 is a block diagram illustrating one embodiment of a transmitter output stage that includes an amplifier stage operable to amplify a plurality of signals;

FIGURE 4 is a block diagram illustrating another embodiment of a transmitter output stage that includes an amplifier stage operable to amplify a plurality of signals; and

FIGURE 5 is a flowchart illustrating one embodiment of a method for amplifying a signal that may be used by the amplifier stage of the modifying communication device of FIGURE 1.

It will be appreciated that for simplicity and clarity of illustration, elements shown in the figures have not necessarily been drawn to scale. For example, the dimensions of some of the elements may be exaggerated relative to other elements for clarity. Further, where considered appropriate, reference numerals may be repeated among the figures to indicate corresponding or analogous elements.

## DETAILED DESCRIPTION OF EMBODIMENTS OF THE INVENTION

In the following detailed description, numerous specific details are set forth in order to provide a thorough understanding of the invention. However, it will be understood by those skilled in the art that the present invention may be practiced without these specific details. In other instances, well-known methods, procedures, and components have not been described in detail so as not to obscure the present invention.

According to embodiments of the invention, transmit diversity techniques may use fractional power amplifiers. In operation, lower total power than full power may be required, but there may be instances when transmit diversity is not effective. In such instances, for example, either more power may be required, or single channel full power may be preferred.

According to one embodiment of the invention, there may be provided at least a fractional power amplifier, or in some embodiments of the invention a plurality of power amplifiers including a fractional power amplifier, and a switching arrangement such that none, one, selected some or all amplifiers may be enabled and none, one, some or all amplifiers may be bypassed. If the power level at the input to the power amplifier is sufficiently high, the power amplifier may be bypassed, saving its operating current. The current typically drawn by a bypass switch may be much smaller than the quiescent current of the power amplifier. The current savings may apply to each power amplifier of the multiple power amplifiers.

The quiescent current of an amplifier may refer to the current that the amplifier draws from the power supply when the output power of the amplifier is small or minimal, for example, for a minimum signal input. The quiescent current, which may be proportional to the amplifier rated power, may contribute to the total current required by the amplifier at low signal levels. Thus, the higher the quiescent current, the lower the amplifier efficiency when averaged over the statistics of used levels of the amplifier, or the probability of different transmit power levels.

Power amplifiers may be subject to variable efficiency of the device, which may degrade as a function of the power output. For example, the efficiency (PAE) at a maximum power level may be three to four times better than the efficiency at a medium power level, and the efficiency may be lower at a low power level. The variable efficiency is partly due to the quiescent current, which may have a contribution to overall consumption for all power outputs.

Variable efficiency may negatively affect transmit diversity techniques. For example, while operating at relatively high power levels, the simultaneous usage of two power amplifier devices of a transmit diversity device may require less total power output, and thus less current consumption, than a single full power amplifier stage of a single channel transmit device, which may provide a current consumption advantage. The current consumption advantage, however, may be compromised when operating in medium or low power outputs. Due to reduced amplifier efficiency, the reduction of required power output may no longer be translated to a reduction of current consumption. Accordingly, in some embodiments of the invention, a bypass power amplifier technique, which may nullify or significantly reduce the quiescent current, may yield current consumption saving for power levels ranging from high, medium, and low power levels.

According the some embodiments of the invention, there may be provided a transmit path having at least one fractional or full power amplifier, and at least one bypass switch so as to select the fractional or full power amplifier or to select a bypass path bypassing the amplifier. It will be understood that the fractional or full power amplifier may be a single or multiple stage amplifier. Combinations are possible, for example, in one embodiment of the invention, a transmit path having a multiple stage amplifier, in which some stages may be bypassed by a bypass switch directing the transmit path to a bypass path bypassing the partial stage of the multiple stage amplifier. A transmit path having a multiple stage amplifier may have a plurality of bypass switches each to bypass a selected subset of stages. It will be further understood that in an embodiment of the invention, a transmit diversity device may have one, some or all transmit paths with a full or partial bypass arrangement.

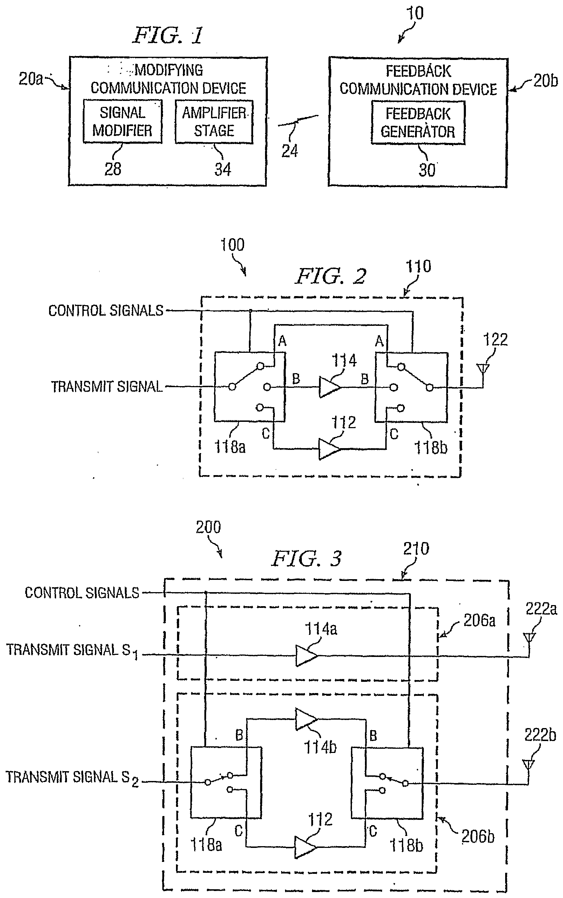

FIGURE 1 depicts a block diagram of one embodiment of a communication network 10 that may include a modifying communication device 20a. Said modifying communication device 20a may include an amplifier stage 34. Said amplifier stage 34 may include a full power amplifier, a fractional power amplifier, or both a full power amplifier and a fractional power amplifier. The fractional power amplifier may be selected to amplify a transmit signal using a fractional power. In some embodiments of the invention, the fractional power amplifier may consume less power than a full power amplifier, and the power consumption of the amplifier stage may thus be decreased.

In some embodiments of the present invention, modifying communication device 20a may implement a diversity control operation. Modifying communication device 20a may apply a diversity parameter adjustment to a signal transmitted to feedback communication device 20b. Feedback communication device 20b may return feedback information that may describe the signal as received by feedback communication device 20b. Modifying communication device 20a may determine a next diversity parameter adjustment in accordance with the feedback information.

In some embodiments of the present invention, network 10 may operate to provide services, for example, communication sessions. A communication session may refer to an active communication between endpoints, as measured, for example, from endpoint to endpoint. Information, for example, voice, data, text, audio, video, multimedia, control, signaling, other information, or any combination of the preceding, may be communicated during a communication session.

A base station may provide a subscriber unit access to a communication network that allows the subscriber unit to communicate with other networks or devices. A base station may typically include a base transceiver station and a base station controller. The base transceiver station may communicate signals to and from one or more subscriber units. The base station controller may manage the operation of the base transceiver station.

Information may be communicated, for example, in packets, where a packet may comprise a bundle of data organized in a specific way for transmission. A frame may comprise the payload of, for example, one or more packets organized in a specific way for transmission. A packet-based communication protocol such as, for example, Internet Protocol (IP) may be used to communicate the packets. A packet may comprise any suitable packet, such as, for example, a General Packet Radio Service (GPRS) packet, or, for example, an Enhanced Data for GSM Evolutions (EDGE) packet, or any other suitable packet.

In some embodiments network 10 may utilize communication protocols and technologies to provide the communication sessions. Communication protocols and technologies may include, for example, those of the Institute of Electrical and Electronics Engineers (IEEE) 802.xx standards and other IEEE standards, International Telecommunications Union (ITU-T) standards including, for example, the IMT-2000 standards, European Telecommunications Standards Institute (ETSI) standards including, for example, the HIPERLAN and HIPERLAN2 local area network standards, Internet Engineering Task Force (IETF) standards, Third Generation Partnership Project (3GPP) or 3GPP2 standards, or other standards.

In some embodiments devices of network 10 may use any suitable access technology, for example, frequency division duplex (FDD), time division duplex (TDD), code division multiple access (CDMA), or orthogonal frequency division multiplex (OFDM) technology. In some embodiments, network 10 may operate, for example, according to a CDMA 2000 telecommunications technology that may use a single CDMA channel. For example, a CDMA 2000 high rate data packet technology such as the Evolution Data Only (EvDO) technology may be used.

In some embodiments network 10 may comprise any suitable communication network. A communication network may comprise all or a portion of, for example, a public switched telephone network (PSTN), a public or private data network, a local area network (LAN), a metropolitan area network (MAN), a wide area network (WAN), a wireline or wireless network, a local, regional, or global communication network such as, for example, the Internet, an enterprise intranet, other suitable communication link, or any combination of the preceding.

In some embodiments network 10 may include one or more modifying communication devices 20a and one or more feedback communication devices 20b that may communicate via a wireless link 24. A communication device 20 may represent any device operable to communicate information via signals with one or more other communication devices 20. For example, communication device 20 may comprise a subscriber unit or a base station. A subscriber unit may comprise any device operable to communicate with a base station, for example, a personal digital assistant, a cellular telephone, a mobile handset, a computer, or any other device suitable for communicating signals to and from a base station. A subscriber unit may support, for example, Session Initiation Protocol (SIP) or any other suitable communication protocol.

In some embodiments a communication device 20 may include one or more antenna elements, where each antenna element may be operable to receive, transmit, or both receive and transmit a signal. Wireless link 24 between communication devices 20a and 20b may be a radio frequency link that may be used to communicate a signal between communication devices 20a and 20b.

In some embodiments modifying communication device 20a may include a signal modifier 28 that may modify one or more signals in accordance with feedback information that may be received from feedback communication device 20b. In some embodiments modifying a signal may be described as applying a diversity parameter adjustment, for example, an absolute power adjustment. Absolute power may refer to the total power transmitted by modifying communication device 20a.

In some embodiments a signal may be modified by applying a diversity parameter adjustment to the signal. In some embodiments, a next diversity parameter adjustment $\vec{f}(k+1)$ may be calculated from a current diversity parameter adjustment $\vec{f}(k)$ and a diversity parameter increment adjustment $\Delta\vec{f}(k)$ according to

$$\vec{f}(k+1) = \vec{f}(k) + \Delta\vec{f}(k),$$ where $k$ represents an iteration.

In some embodiments signal modifier 28 may use feedback information to determine a diversity parameter adjustment for a next window. The feedback information may indicate, for example, whether modifying communication device 20a should increase or reduce transmission power. Feedback information may be obtained from a feedback signal in any suitable manner.

In some embodiments, for example, signal modifier 28 may obtain feedback information from a quality indication signal that may be received from feedback communication device 20b. A quality indication signal may refer to a signal that describes a quality of a signal transmitted by modifying communication device 20a as received by feedback communication device 20b.

In some embodiments, for example, signal modifier 28 obtains feedback information from a control signal that may be generated by a baseband subsystem of modifying communication device 20a. A control signal may refer to a signal that may be derived from the feedback information and may provide instructions to a component of, for example, a communication device.

In some embodiments amplifier stage 34 may include a fractional power amplifier, or a full power amplifier and a fractional power amplifier. The fractional power amplifier may be selected to amplify a transmit signal using a fractional power. Some embodiments of amplifier stage 34 may be described with reference to FIGURES 2, 3, and 4, although it should not be construed that these are limiting descriptions.

In some embodiments feedback communication device 20b generates feedback information that reflects the quality of the received modified signals. The quality may be determined in any suitable manner. As an example, a higher signal-to-noise ratio (SNR), or energy per bit to the spectral noise density ($E_bN_0$), may indicate a higher signal quality. In other examples, the quality may be determined using any suitable measurements, for example, receive signal power ($P_R$), bit error rate (BER), frame error rate (FER), other measurement, or any suitable combination of the preceding. A higher received signal power, a lower bit error rate, or a lower frame error rate may indicate, for example, a higher signal quality.

In some embodiments feedback communication device 20b may include a feedback generator 30 that may generate feedback information that may depict the quality of the modified signals. The feedback information may include one or more quality indicators. In some embodiments a quality indicator may instruct modifying communication device 20a to increase or decrease transmission power. A quality indicator may comprise, for example, a power control bit (PCB) of a code division multiple access (CDMA) power control signal or, for example, a transmit power control bit (TPB) of a wideband code division multiple access (WCDMA) power control signal. The quality indicators may be sent to modifying communication device 20a via a quality indication signal. In some embodiments a quality indicator may identify specific diversity parameter values that are better than other diversity parameter values. For example, the quality indicators may indicate that a specific test that tests a specific diversity parameter vector is better than the other tests.

In some embodiments a device of network 10 may include logic, an interface, memory, other component, or any suitable combination of the preceding. Said logic may refer to hardware, software, other logic, or any suitable combination of the preceding. Certain logic may manage the operation of a device, and may comprise, for example, a processor. Said interface may refer to logic of a device operable to receive input for the device, send output from the device, perform suitable processing of the input or output or both, or any combination of the preceding, and may comprise one or more ports, conversion software, or both. Said memory may refer to logic operable to store and facilitate retrieval of information, and may comprise, for example, Random Access Memory (RAM), Read Only Memory (ROM), a magnetic drive, a disk drive, a Compact Disk (CD) drive, a Digital Video Disk (DVD) drive, removable media storage, any other suitable data storage medium, or any suitable combination of the preceding.

In certain examples, various modifications, additions, or omissions may be made to communication network 10. Additionally, operations of communication network 10 may be performed using any suitable logic. As used in this document, "each" refers to each member of a set or each member of a subset of a set. A subset of a set may include none, some, or all elements of the set.

FIGURE 2 is a block diagram illustrating one embodiment of a transmitter (Tx) output stage 100 that includes an amplifier stage 110 operable to amplify a signal. In some embodiments, Tx output stage 100 may be used with modifying communication device 20a.

In one embodiment of the present invention, Tx output stage 100 may include power amplifier stage 110 and may include an antenna 122 that may be coupled as shown. Power amplifier stage 110 may receive a transmit signal through an input, amplify the signal, and may send the amplified signal through an output coupled to antenna 122. Power amplifier stage 110 may include a plurality of power amplifiers 112 and 114 and a plurality of switches 118a and 118b coupled as shown.

Power amplifier stage 110 may include any suitable number of power amplifiers, for example, amplifiers 112 and 114. A power amplifier may comprise any suitable amplifier operable to amplify a signal. For example, a power amplifier may comprise a radio frequency (RF) analog signal amplifier. The signal amplifier may be formed of one or more stages and may provide linear or non-linear amplification, for example, logarithmic amplification.

In one embodiment, power amplifiers 112 and 114 may include zero or more full power amplifiers 112 and one or more fractional power amplifiers 114. A full power amplifier 112 may represent a power amplifier that may provide full power to amplify signals up to a specification power limit. According to embodiments of the invention, full power may refer to the maximum power required by a non-diversity device that yields a power level at the antenna input that satisfies the requirement of any suitable air interface standard. It will be recognized that full power may be higher than specified in a standard in order to account for losses between the amplifier output and the antenna input. For example, a power amplifier such as the AWT6135 power amplifier from ANADIGICS, INC., amplifies up to +28 dBm for CDMA2000. Full power amplifier 112 may be designed such that its maximum power efficiency may coincide with the full power output. Full power may be used at any suitable time, for example, when modifying communication device 20a is far from feedback communication device 20b.

A fractional power amplifier 114 may represent a power amplifier that provides fractional power to amplify signals up to a portion of a specification power limit. Fractional power may refer to any suitable portion, for example, one-half power, one-quarter power, or x/y power for any suitable x and y, where the ratio x/y may be less than or equal to one. Fractional power may be used at any suitable time, for example, during normal operation of modifying communication device 20a. Fractional power amplifier 114 may be designed such that its maximum power efficiency may coincide with the fractional power output. In some embodiments of the invention, the quiescent current of a fractional power amplifier may be a fraction of the quiescent current of a full power amplifier.

In some embodiments the rated power of fractional power amplifier 114 may be a fraction of the rated power of full power amplifier 112, so the power consumption of fractional power amplifier 114 may be proportionally lower that the power consumption of full power amplifier 112.

In one embodiment, fractional power amplifiers 114 may include a plurality of fractional power amplifiers 114. Fractional power amplifiers 114 may be placed in parallel, and may have the same or different fractional powers. A fractional power amplifier 114 may be selected by switches 118a and 118b controlled by control signals. Fractional power amplifiers 114 may amplify signals using different power levels.

In some embodiments switches 118a and 118b may represent RF switches that may steer signals to amplifier 112, amplifier 114, bypass path, or any suitable combination of the preceding. A switch 118a or 118b may have any suitable number $m$ of positions. As an example, switch 118a or 118b may have $m = n + 1$ positions to accommodate n amplifiers 112 and 114 and a bypass path. In one embodiment of figure 2, a switch 118 may have $m = 3$ positions labeled A, B, and C. The A positions may direct a signal to a path that may bypass full power amplifier 112 and fractional power amplifier 114, the B positions may direct a signal to fractional power amplifier 114, and the C positions may direct the transmit signal to full power amplifier 112.

In some embodiments of the invention, bypassing a power amplifier while still maintaining the full transmit dynamic range of a transmitting chain may require adding an additional control to the power amplifier or changing the switching point currently controlling the state, e.g., the high/low power amplifier gain, of the power amplifier. According to one embodiment of the invention, modifying communication device 20a may include a vector modulator coupled between an upconverter and power amplifiers 112 and 114. Level shifting may be used to allow a current control sent from a baseband processor to a power amplifier 112 and 114 to bypass the power amplifier 112 and 114.

A control input of switch 118a or 118b receives a control signal. The control signal controls the position of switch 118a or 118b, and may be sent by a controller of modifying communication device 20a, for example, the MSM7500 chipset from QUALCOMM INCORPORATED. The control signal may, for example, represent a portion of a digital control bus or, for example, signals derived from a digital control bus.

Any suitable control signal may be used. According to one embodiment of the invention, the control signal may comprise a logic control signal such as a power amplifier state control signal. A state control signal that switches between amplification levels may be used to switch between an active power amplifier and a bypassed power amplifier. According to another embodiment of the invention, the control signal may comprise a logic signal derived from a multi-level control signal. For example, the control signal may comprise a transmit level signal that may control the output level of an upconverter, and that may be provided by a baseband controller. According to another embodiment of the invention, the control signal may comprise a separate logic control signal, for example, a signal from a baseband controller.

Antenna 122 may represent an RF antenna operable to receive, transmit, or both receive and transmit a signal. Antenna 122 may comprise, for example, a typical handset antenna, such as a retractable antenna.

Modifications, additions, or omissions may be made to power amplifier stage 110 without departing from the scope of the invention. The components of power amplifier stage 110 may be integrated or separated according to particular needs. For example, the present invention contemplates some or all of amplifiers 112 and 114 and switches 118a and 118b being provided at a single device, for example, a single integrated circuit. If any of the components of power amplifier stage 110 are separated, the separated components may be coupled using a bus or other suitable link. Moreover, the operations of power amplifier stage 110 may be performed by more, fewer, or other components. Additionally, operations of power amplifier stage 110 may be performed using any suitable logic.

FIGURE 3 is a block diagram illustrating one embodiment of a transmitter (Tx) output stage 200 that may include an amplifier stage 210 operable to amplify a plurality of signals. According to one embodiment, Tx output stage 200 may be used with modifying communication device 20a.

In one embodiment, Tx output stage 200 may include power amplifier stage 210 and antennas 222a and 222b coupled as shown. Power amplifier stage 210 may receive transmit signals $S_1$ and $S_2$ through inputs, may amplify the signals, and may send the amplified signals through an output coupled to antennas 222a and 222b. Power amplifier stage 210 may comprise any suitable number of channels 206. According to the illustrated embodiment, channel 206a may amplify signal $S_1$, and channel 206b may amplify signal $S_2$. Channels 206a and 206b may comprise any suitable number $n$ of power amplifiers 112 and 114 and may comprise a plurality of switches 118a and 118b coupled to a plurality of antennas 222 as shown. According to the illustrated embodiment, channel 206a may comprise fractional power amplifier 114a coupled to antenna 222a, and channel 206b may comprise fractional power amplifier 114b, full power amplifier 112, and switches 118a and 118b coupled to antenna 222b.

In one embodiment, a switch 118a or 118b may have $m$ = 2 positions, labeled B and C, which may accommodate fractional power amplifier 114b and full power amplifier 112. The B positions may direct a signal to fractional power amplifier 114b. The output of fractional power amplifiers 114b may be maximized by, for example, the setting of their internal gain, and the output of fractional power amplifiers 114b may be minimized by, for example, the setting of their internal gain. The C positions may direct a signal to full power amplifier 112.

Antennas 222a and 222b may represent RF antennas operable to receive, transmit, or both receive and transmit a signal. Antennas 222a and 222b may comprise, for example whip, chip, or slot antennas.

Modifications, additions, or omissions may be made to power amplifier stage 210 without departing from the scope of the invention. The components of power amplifier stage 210 may be integrated or separated according to particular needs. For example, the present invention contemplates some or all of amplifiers 112 and 114a and 114b and switches 118a and 118b being provided at a single device, for example, a single integrated circuit. If any of the components of power amplifier stage 210 are separated, the separated components may be coupled using a bus or other suitable link. Moreover, the operations of power amplifier stage 210 may be performed by more, fewer, or other modules. Additionally, operations of power amplifier stage 210 may be performed using any suitable logic.

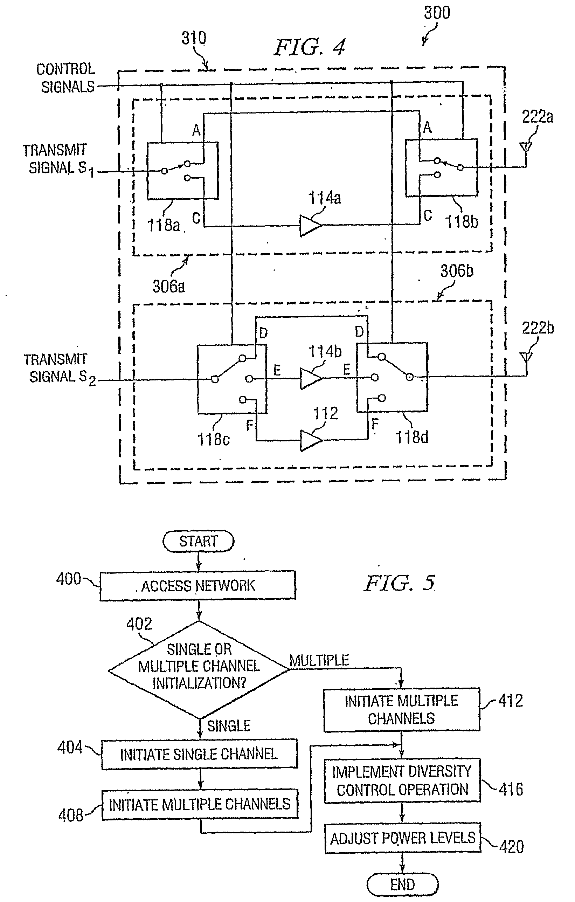

FIGURE 4 is a block diagram illustrating one embodiment of a transmitter (Tx) output stage 300 that may include an amplifier stage 310 operable to amplify a plurality of signals. According to one embodiment, Tx output stage 300 may be used with modifying communication device 20a.

In one embodiment of the present invention, as depicted in figure 4, Tx output stage 300 may include power amplifier stage 310 and antennas 222a and 222b coupled as shown. Power amplifier stage 310 may receive transmit signals $S_1$ and $S_2$ through inputs, may amplify the signals, and may send the amplified signals through an output coupled to antennas 222a and 222b.

Power amplifier stage 210 may comprise any suitable number of channels 306a or 306b. According to the illustrated embodiment, channel 306a may amplify signal $S_1$, and channel 306b may amplify signal $S_2$. Channels 306a and 306b may comprise any suitable number $n$ of power amplifiers 112 and 114a and 114b and a plurality of switches 118a, 118b, 118c, and 118d coupled to a plurality of antennas 222a and 222b as shown. According to the illustrated embodiment, channel 306a may comprise fractional power amplifier 114a and switches 118a and 118b coupled to antenna 222a, and channel 306b may comprise fractional power amplifier 114b, full power amplifier 112, and switches 118c and 118d coupled to antenna 222b.

According to the illustrated embodiment, switches 118a and 118b may have $m$ = 2 positions, labeled A and C, that may accommodate a bypass path and fractional power amplifier 114a. The A positions may direct a signal to the bypass path, and the C positions may direct a signal to fractional power amplifier 114a. Switches 118c and 118d may have $m$ = 3 positions, labeled D, E, and F, that may accommodate a bypass path, fractional power amplifier 114b, and full power amplifier 112. The A positions may direct a signal to the bypass path, the B positions may direct a signal to fractional power amplifier 114b, and the C positions may direct a signal to full power amplifier 112.

Antennas 222a and 222b may represent RF antennas operable to receive, transmit, or both receive and transmit a signal. Antennas 222a and 222b may comprise, for example whip, chip, or slot antennas.

In certain examples, various modifications, additions, or omissions may be made to power amplifier stage 310. The components of power amplifier stage 310 may be integrated or separated according to particular needs. For example, the present invention contemplates some or all of amplifiers 112 and 114a and 114b and switches 118a and 118b being provided using a single device, for example, a single integrated circuit. If any of the components of power amplifier stage 310 are separated, the separated components may be coupled using a bus or other suitable link. Moreover, the operations of power amplifier stage 310 may be performed by more, fewer, or other modules. Additionally, operations of power amplifier stage 310 may be performed using any suitable logic.

According to one embodiment, at any time one, some, or all of the transmit paths, whether going through the power amplifiers or bypassing the power amplifiers, may be activated. The activation of power amplifier bypass (any of 118a, 118b, 118c, 118d) may be based on the required transmit power level, and it may be controlled by any one or more of the following of one or more embodiments:

(1) An existing logic control signal, such as an existing power amplifier state control signal. An existing power amplifier state control signal may effectively switch a power amplifier between two amplification levels. The signal may be used to switch states between an active power amplifier state and a bypassed power amplifier state. In some embodiments of the invention, a software modification may be used to implement this example;

(2) A logic signal derived from a multi-level control signal, such as a transmit level signal provided by a baseband controller. The transmit level signal may primarily control the output level from the upconverter; and

(3) A separate logic control signal, for example an additional output from the baseband.

It will be recognized that other implementations of the logic control may be implemented within the scope of the present invention.

FIGURE 5 is a flowchart illustrating one embodiment of a method for amplifying a signal that may be used by amplifier stage 34 of modifying communication device 20a of FIGURE 1.

In this embodiment, the method begins at step 400, where a network comprising feedback communication device 20b may be accessed by modifying communication device 20a. Single or multiple channel initialization may be performed at step 402. During initialization, any suitable combination of one or more amplifiers 112 and 114a and 114b may be utilized to amplify one or more transmit signals for transmission by one or more antennas 122 and 222a and 222b. In single channel initialization, a single antenna may transmit signals. In multiple channel initialization, multiple antennas may transmit signals, which may provide for diversity control.

If single channel initialization is to be performed at step 402, the method may proceed to step 404, where a single channel may be initialized. The initialization may be performed in any suitable manner. For example, a first signal may be directed to a bypass path, and a second signal may be directed to a full power amplifier 112 to yield full transmit power. Multiple channels are initiated at step 412. The multiple channels may be initiated in any suitable manner. For example, a first signal may be directed to a first fractional power amplifier 114b, and a second signal may be directed to a second fractional power amplifier 114b to perform a diversity control operation. The method then proceeds to step 416.

If multiple channel initialization is to be performed at step 402, the method may proceed to step 412, where multiple channels may be initialized. The initialization may be performed in any suitable manner, for example, as described with reference to step 408. The method then proceeds to step 416.

A diversity control operation is implemented at step 416. Any suitable diversity control operation may be used. Power levels may be adjusted at step 424. Power levels may be adjusted in response to any suitable situation. For example, the power may be decreased if modifying communication device 20a moves closer to feedback communication device 20b. Power levels may be adjusted in any suitable manner, for example, in a manner described with reference to steps 404 or 412. After adjusting the power levels, the method terminates.

Modifications, additions, or omissions may be made to the method without departing from the scope of the invention. The method may include more, fewer, or other steps. Additionally, steps may be performed in any suitable order without departing from the scope of the invention.

In some embodiments, the multiple transmit signals may be used to perform a diversity control operation.

While certain features of the invention have been illustrated and described herein purely by way of example, many modifications, substitutions, changes, and equivalents can be made within the scope of the invention.

**Claims**

1. A mobile wireless communication device (20a) comprising:

a signal modifier (28) in said mobile wireless communication device to receive an input signal and produce a first transmit signal (S1) differing by a diversity parameter adjustment from a second transmit signal (S2); and

a transmit amplifier stage (34) in said mobile wireless communication device operable to amplify said first and second transmit signals, comprising:

a first channel (206a) comprising at least one first power amplifier (114a) operable to provide power to amplify the first transmit signal for transmission by a first antenna (222a) at a first fractional power, wherein a substantially maximum efficiency of the first power amplifier substantially coincides with the first fractional power, the first fractional power being a first fraction of a specification power limit of the wireless device; and

a second channel (206b) comprising at least one second power amplifier (114b) operable to amplify the second transmit signal for transmission by a second antenna (222b) at a second fractional power, wherein a substantially maximum efficiency of the second power amplifier substantially coincides with the second fractional power, the second fractional power being a second fraction of the specification power limit of the wireless device,

wherein said signal modifier is further to produce said diversity parameter adjustment based on a feedback signal received from a receiver of said first and second transmit signals.

2. The wireless communication device of claim 1, wherein the second channel further comprises:

a plurality of second power amplifiers (114b and 112), each providing a different power amplification to said second transmit signal; and one or more switches (118a and 118b), each of which having a plurality of positions, a position operable to direct the second transmit signal to a selected power amplifier of the plurality of second power amplifiers.

3. The wireless communication device of claim 2, wherein said plurality of second power amplifiers includes said second power amplifier (114b) operable to amplify the second transmit signal at said second fractional power, and at least one full power amplifier (112) operable to amplify the second transmit signal at said specification power limit.

4. The wireless communication device of any of the preceding claims, wherein at least one of said first and second channels consists essentially of said respective fractional power amplifier.

5. The wireless communication device of any of the preceding claims, wherein at least one or both of said first and second fractional powers is less than half of said specification power limit.

6. The wireless communication device of any of the preceding claims, wherein at least one or both of said first and second fractional powers is a quarter of said specification power limit.

7. A method for transmission of a signal, comprising:

receiving an input signal for transmission; producing based on said input signal a first transmit signal differing by a diversity parameter adjustment from a second transmit signal; amplifying by a first fractional power the first transmit signal for transmission by a first antenna, the first fractional power being a first fraction of a specification power limit of the mobile wireless communication device, said amplification of the first transmit signal performed by a first fractional power amplifier having a substantially maximum efficiency that substantially coincides with the first fractional power; amplifying by a second fractional power the second transmit signal for transmission by a second antenna, the second fractional power being a second fraction of the specification power limit of the mobile wireless communication device, said amplification of the second transmit signal performed by a second fractional power amplifier having a substantially maximum efficiency that substantially coincides with the second fractional power; transmitting by said mobile wireless communication device said amplified first and second transmit signals, thereby producing transmission of said input signal by said full transmission power; receiving a feedback signal from a receiver of said first and second transmit signals; and producing said diversity parameter adjustment based on said feedback signal.

8. The method of claim 7, wherein amplifying the second transmit signal comprises:

receiving one or more control signals comprising an instruction for amplifying the second transmit signal; selecting a position of a plurality of positions of at least one switch in accordance with the control signal, a position operable to direct the second transmit signal to a corresponding second power amplifier of a plurality of second power amplifiers, the plurality of second power amplifiers including a full power amplifier operable to provide the specification power limit of the wireless device, and a fractional power amplifier operable to provide said second fractional power; and amplifying the second transmit signal using the selected second power amplifier corresponding to the selected position.

9. The method of claim 7 or 8, wherein at least one or both of said first and second fractional powers is less than half of the specification power limit.

10. The method of claim any of claims 7 to 9, wherein at least one or both of said first and second fractional powers is a quarter of the specification power limit.

**Patentansprüche**

1. Mobile drahtlose Kommunikationsvorrichtung (20a), umfassend:

einen Signalmodifizierer (28) in der mobilen drahtlosen Kommunikationsvorrichtung zum Empfangen eines Eingangssignals und zum Erzeugen eines ersten Sendesignals (S1), das sich um eine Diversityparametereinstellung von einem zweiten Sendesignal (S2) unterscheidet; und eine Sendeverstärkerstufe (34) in der mobilen drahtlosen Kommunikationsvorrichtung, die im Betrieb das erste und das zweite Sendesignal verstärkt, umfassend:

einen ersten Kanal (206a), umfassend wenigstens einen ersten Leistungsverstärker (114a), der im Betrieb Leistung bereitstellt, um das erste Sendesignal zum Senden durch eine erste Antenne (222a) bei einer ersten Bruchteilsleistung zu verstärken, wobei eine im Wesentlichen maximale Effizienz des ersten Leistungsverstärkers im Wesentlichen mit der ersten Bruchteilsleistung zusammenfällt, wobei die erste Bruchteilsleistung ein erster Bruchteil einer Spezifikationsleistungsgrenze der drahtlosen Vorrichtung ist; und
einen zweiten Kanal (206b) umfassend wenigstens einen zweiten Leistungsverstärker (114b), der im Betrieb das zweite Sendesignal zum Senden durch eine zweite Antenne (222b) bei einer zweiten Bruchteilsleistung verstärkt, wobei eine im Wesentlichen maximale Effizienz des zweiten Leistungsverstärkers im Wesentlichen mit der zweiten Bruchteilsleistung zusammenfällt, wobei die zweite Bruchteilsleistung ein zweiter Bruchteil der Spezifikationsleistungsgrenze der drahtlosen Vorrichtung ist,

wobei der Signalmodifizierer ferner dazu ausgelegt ist, die Diversityparametereinstellung basierend auf einem Rückkopplungssignal zu erzeugen, das von einem Empfänger des ersten und des zweiten Sendesignals empfangen wird.

2. Drahtlose Kommunikationsvorrichtung nach Anspruch 1, wobei der zweite Kanal ferner umfasst:

eine Mehrzahl von zweiten Leistungsverstärkern (114b und 112), von denen jeder eine unterschiedliche Leistungsverstärkung bei dem zweiten Sendesignal bereitstellt; und
einen oder mehr Schalter (118a und 118b), von denen jeder eine Mehrzahl von Positionen hat, wobei eine Position im Betrieb das zweite Sendesignal zu einem ausgewählten Leistungsverstärker aus der Mehrzahl von zweiten Leistungsverstärkern lenkt.

3. Drahtlose Kommunikationsvorrichtung nach Anspruch 2, wobei die Mehrzahl von zweiten Leistungsverstärkern den zweiten Leistungsverstärker (114b) enthält, der im Betrieb das zweite Sendesignal bei der zweiten Bruchteilsleistung verstärkt, sowie wenigstens einen Vollleistungsverstärker (112), der im Betrieb das zweite Sendesignal bei der Spezifikationsleistungsgrenze verstärkt.

4. Drahtlose Kommunikationsvorrichtung nach einem der vorhergehenden Ansprüche, wobei der erste und/oder der zweite Kanal im Wesentlichen aus dem jeweiligen Bruchteilsleistungsverstärker besteht.

5. Drahtlose Kommunikationsvorrichtung nach einem der vorhergehenden Ansprüche, wobei wenigstens eine oder beide von der ersten und der zweiten Bruchteilsleistung weniger als die Hälfte der Spezifikationsleistungsgrenze ist.

6. Drahtlose Kommunikationsvorrichtung nach einem der vorhergehenden Ansprüche, wobei wenigstens eine oder beide von der ersten und zweiten Bruchteilsleistung ein Viertel der Spezifikationsleistungsgrenze ist.

7. Verfahren zum Senden eines Signals, umfassend:

Empfangen eines Eingangssignals zum Senden;
Erzeugen, basierend auf dem Eingangssignal, eines ersten Sendesignals, das sich um eine Diversityparametereinstellung von einem zweiten Sendesignal unterscheidet;
Verstärken des ersten Sendesignals um eine erste Bruchteilsleistung zum Senden durch eine erste Antenne, wobei die erste Bruchteilsleistung ein erster Bruchteil einer Spezifikationsleistungsgrenze der mobilen drahtlosen Kommunikationsvorrichtung ist, wobei die Verstärkung des ersten Sendesignals, die durch einen ersten Bruchteilsleistungsverstärker durchgeführt wird, eine im Wesentlichen maximale Effizienz hat, die im Wesentlichen mit der ersten Bruchteilsleistung zusammenfällt;
Verstärken des zweiten Sendesignals um eine zweite Bruchteilsleistung zum Senden durch eine zweite Antenne, wobei die zweite Bruchteilsleistung ein zweiter Bruchteil der Spezifikationsleistungsgrenze der mobilen drahtlosen Kommunikationsvorrichtung ist, wobei die Verstärkung des zweiten Sendesignals, die durch einen zweiten Bruchteilsleistungsverstärker durchgeführt wird, eine im Wesentlichen maximale Effizienz hat, die im Wesentlichen mit der zweiten Bruchteilsleistung zusammenfällt;
Senden, durch die mobile drahtlose Kommunikationsvorrichtung, des verstärkten ersten und zweiten Sendesignals, wodurch ein Senden des Eingangssignals mit der vollen Sendeleistung erzeugt wird;
Empfangen eines Rückkopplungssignals von einem Empfänger des ersten und des zweiten Sendesignals; und
Erzeugen der Diversityparametereinstellung basierend auf dem Rückkopplungssignal.

**8.** Verfahren nach Anspruch 7, wobei das Verstärken des zweiten Sendesignals umfasst:

Empfangen von einem oder mehr Steuersignalen, umfassend einen Befehl zum Verstärken des zweiten Sendesignals;

Auswählen einer Position aus einer Mehrzahl von Positionen von wenigstens einem Schalter in Übereinstimmung mit dem Steuersignal, wobei eine Position im Betrieb das zweite Sendesignal zu einem entsprechenden zweiten Leistungsverstärker aus einer Mehrzahl von zweiten Leistungsverstärkern lenkt, wobei die Mehrzahl der zweiten Leistungsverstärkern einen Vollleistungsverstärker enthält, der im Betrieb die Spezifikationsleistungsgrenze der drahtlosen Vorrichtung bereitstellt, sowie einen Bruchteilsleistungsverstärker, der im Betrieb die zweite Bruchteilsleistung bereitstellt; und

Verstärken des zweiten Sendesignals unter Verwendung des ausgewählten zweiten Leistungsverstärkers entsprechend der ausgewählten Position.

**9.** Verfahren nach Anspruch 7 oder 8, wobei wenigstens eine oder beide von der ersten und der zweiten Bruchteilsleistung kleiner als die Hälfte der Spezifikationsleistungsgrenze ist.

**10.** Verfahren nach einem der Ansprüche 7 bis 9, wobei wenigstens eine oder beide von der ersten und zweiten Bruchteilsleistung ein Viertel der Spezifikationsleistungsgrenze ist.

**Revendications**

**1.** Dispositif de communication sans fil mobile (20a) comprenant :

un modificateur de signaux (28) dans ledit dispositif mobile de communication sans fil pour recevoir un signal d'entrée et produire un premier signal de transmission (S1) qui diffère par un réglage de paramètre de diversité depuis un deuxième signal de transmission (S2) ; et

une étape amplificateur d'émission (34) dans ledit dispositif mobile de communication sans fil servant à amplifier lesdits premier et deuxième signaux de transmission, comprenant :

un premier canal (206a) comprenant au moins un premier amplificateur de puissance (114a) servant à fournir de la puissance pour amplifier le premier signal de transmission pour une transmission par une première antenne (222a) au niveau d'une première puissance fractionnelle, dans lequel une efficacité substantiellement maximale du premier amplificateur de puissance coïncide substantiellement avec la première puissance fractionnelle, la première puissance fractionnelle étant une première fraction d'une limite de puissance de spécification du dispositif sans fil ; et

un deuxième canal (206b) comprenant au moins un deuxième amplificateur de puissance (114b) servant à amplifier le deuxième signal de transmission pour une transmission par une deuxième antenne (222b) au niveau d'une deuxième puissance fractionnelle, dans lequel une efficacité substantiellement maximale du deuxième amplificateur de puissance coïncide substantiellement avec la deuxième puissance fractionnelle, la deuxième puissance fractionnelle étant une deuxième fraction de la limite de puissance de spécification du dispositif sans fil,

dans lequel ledit modificateur de signaux est destiné en outre pour produire ledit réglage de paramètre de diversité sur base d'un signal de retour reçu depuis un récepteur desdits premier et deuxième signaux de transmission.

**2.** Dispositif de communication sans fil selon la revendication 1, dans lequel le deuxième canal comprenant en outre :

une pluralité de deuxièmes amplificateurs de puissance (114b et 112), chacun fournissant une amplification différente de puissance audit deuxième signal de transmission ; et

un ou plusieurs commutateurs (118a et 118b), chacun d'eux ayant une pluralité de positions, une position servant à diriger le deuxième signal de transmission à un amplificateur de puissance choisi parmi la pluralité de deuxièmes amplificateurs de puissance.

**3.** Dispositif de communication sans fil selon la revendication 2, dans lequel ladite pluralité de deuxième amplificateurs de puissance inclut ledit deuxième amplificateur de puissance (114b) servant à amplifier le deuxième signal de transmission au niveau de ladite deuxième puissance fractionnelle, et au moins un plein amplificateur de puissance (112) servant à amplifier le deuxième signal de transmission au niveau de ladite limite de puissance de spécification.

**4.** Dispositif de communication sans fil selon l'une quelconque des revendications précédentes, dans lequel au moins un parmi lesdits premier et deuxième canaux consiste essentiellement en ledit amplificateur de puissance fractionnelle respectif.

**5.** Dispositif de communication sans fil selon l'une quelconque des revendications précédentes, dans lequel au moins une ou les deux desdites première et deuxième puissances fractionnelles est inférieure à la moitié de ladite limite de puissance de spécification.

**6.** Dispositif de communication sans fil selon l'une quelconque des revendications précédentes, dans lequel au moins une ou les deux desdites première et deuxième puissances fractionnelles est un quart de ladite limite de puissance de spécification.

**7.** Procédé de transmission d'un signal, comprenant :

la réception d'un signal d'entrée pour une transmission ;
la production sur base dudit signal d'entrée d'un premier signal de transmission qui diffère par un réglage de paramètre de diversité depuis un deuxième signal de transmission ;
l'amplification grâce à une première puissance fractionnelle du premier signal de transmission pour une transmission par une première antenne, la première puissance fractionnelle étant une première fraction d'une limite de puissance de spécification du dispositif mobile de communication sans fil, ladite amplification du premier signal de transmission exécuté par un premier amplificateur de puissance fractionnelle ayant une efficacité substantiellement maximale qui coïncide substantiellement avec la première puissance fractionnelle ;
l'amplification grâce à une deuxième puissance fractionnelle du deuxième signal de transmission pour une transmission par une deuxième antenne, la deuxième puissance fractionnelle étant une deuxième fraction de la limite de puissance de spécification du dispositif mobile de communication sans fil, ladite amplification du deuxième signal de transmission exécutée par un deuxième amplificateur de puissance fractionnelle ayant une efficacité substantiellement maximale qui coïncide substantiellement avec la deuxième puissance fractionnelle ;
la transmission par ledit dispositif mobile de communication sans fil desdits premier et deuxième signaux de transmission amplifiés, produisant ainsi une transmission dudit signal d'entrée par ladite pleine puissance de transmission ;
la réception d'un signal de retour depuis un récepteur desdits premier et deuxième signaux de transmission ; et
la production dudit réglage de paramètre de diversité sur base dudit signal de retour.

**8.** Procédé selon la revendication 7, dans lequel l'amplification du deuxième signal de transmission comprend :

la réception d'un ou plusieurs signaux de commande comprenant une instruction pour l'amplification du deuxième signal de transmission ;
la sélection d'une position d'une pluralité de positions d'au moins un commutateur selon le signal de commande, une position servant à diriger le deuxième signal de transmission à un deuxième amplificateur de puissance correspondant à une pluralité de deuxièmes amplificateurs de puissance, la pluralité de deuxièmes amplificateurs de puissance incluant un plein amplificateur de puissance servant à fournir la limite de puissance de spécification du dispositif sans fil, et un amplificateur de puissance fractionnelle servant à fournir ladite deuxième puissance fractionnelle ; et
l'amplification du deuxième signal de transmission en utilisant le deuxième amplificateur de puissance choisi correspondant à la position choisie.

**9.** Procédé selon la revendication 7 ou 8, dans lequel au moins une ou les deux desdites première et deuxième puissances fractionnelles est inférieure à la moitié de la limite de puissance de spécification.

**10.** Procédé selon l'une quelconque des revendications 7 à 9, dans lequel au moins une ou les deux desdites première et deuxième puissances fractionnelles est un quart de la limite de puissance de spécification.

## FIG. 1

## FIG. 2

## FIG. 3

*FIG. 4*

*FIG. 5*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6859643 B
- US 5862461 A
- US 20030002594 A